# FASCICULE DE BREVET EUROPEEN

(11) **EP 2 141 810 B1**
(45) Date de publication et mention de la délivrance du brevet: **23.12.2015**
(21) Numéro de dépôt: 09164453.4
(22) Date de dépôt: 02.07.2009
(51) Int. Cl.: H03K 17/96

(54) **Dispositif de commande d'un appareil domotique**
Bedienungsvorrichtung für ein Gerätes zur Gebäudeautomatisierung
Operating device for a home automation apparatus

(30) Priorité: 03.07.2008 FR 0803794
(43) Date de publication de la demande: 06.01.2010
(73) Titulaire: Somfy SAS, 74300 Cluses (FR)
(72) Inventeur: Gigout, Fabrice, 74190 Passy (FR)
(74) Mandataire: Novaimo

(56) Documents cités:
- WO-A-2007/053966
- WO-A-2008/022866
- DE-A1- 10 259 297
- US-A- 5 636 729
- US-A- 5 636 729
- US-A- 5 917 165
- BURK A: "MOMENTARY SWITCHING ALTERNATIVES FOR KEY PAD AND FRONT PANEL APPLICATIONS" ELECTRO INTERNATIONAL CONFERENCE RECORD, WESTERN PERIODICALS CO, VENTURA, CA, US, vol. 18, 1 janvier 1993 (1993-01-01), pages 282-291, XP000381927

## Description

L'invention concerne le domaine des dispositifs de commande d'au moins un appareil domotique. Les appareils domotiques sont des appareils destinés au confort thermique, visuel ou de sécurité dans un bâtiment. L'invention concerne donc notamment les appareils d'éclairage, de chauffage climatisation ou ventilation, de protection solaire, des appareils de fermeture d'écrans comme des volets roulants ou des portes de garage.

Les dispositifs de commande de tels appareils peuvent être fixes, tels que des interrupteurs muraux par exemple, ou nomades, tels que des télécommandes radio ou infra-rouge.

Qu'ils soient fixes ou nomades, ces dispositifs doivent être esthétiques, discrets et ergonomiques. Pour cela, l'interface avec l'utilisateur est souvent réduite. Elle comprend généralement plusieurs touches. Certains dispositifs de commande comprennent des touches sensitives par effet capacitif. Cela permet de détecter la présence d'un élément tel qu'un doigt d'un utilisateur à travers un corps électriquement isolant. En pratique, le fait de placer un doigt dans une zone au regard d'une touche sensitive a pour effet d'engendrer une variation de capacité dépendant notamment de la surface du doigt en vis-à-vis d'une surface de détection de la touche sensitive. En reliant électriquement la touche sensitive à un circuit électronique, il est possible de détecter une variation du courant haute fréquence circulant dans le circuit ainsi constitué par la touche sensitive, le doigt de l'utilisateur et le corps de l'utilisateur relié à la terre. Ainsi, en supprimant les touches mécaniques classiques, on confère à un dispositif de commande une ligne sobre et dépouillée ; mais aussi, une meilleure étanchéité tout en rendant plus facile le nettoyage de l'interface. Un des inconvénients de ces touches sensitives est qu'il n'est pas toujours évident de savoir si la touche a été activée ou non. Pour pallier ce problème, plusieurs dispositifs proposent d'alimenter une diode électroluminescente ou LED, lorsqu'une touche sensitive est activée de manière à éclairer une partie de la façade de l'interface.

Ainsi, le brevet US 6,664,489 et la demande de brevet FR 2 906 947 décrivent des dispositifs de commandes d'appareils électroménagers reprenant les solutions décrites précédemment, c'est-à-dire, un capteur capacitif disposé au contact de la face inférieure d'une plaque de verre formant un couvercle, celui-ci déclenchant l'éclairage d'une LED lorsque la touche est activée. La diffusion dans l'air de la lumière émise par la LED est limitée par des parois solides de guides lumière. La face inférieure du couvercle est éclairée sur une zone. Des caches sont prévus pour ne laisser passer la lumière qu'à travers certaines parties de la zone éclairée. Ces caches peuvent correspondre à la face de détection du capteur capacitif, comme dans le brevet US 6,664,489 ou au couvercle, comme dans la demande FR 2 906 947.Dans le premier cas, le couvercle est translucide et le motif illuminé est reproduit sur la face de détection par des évidements. Dans le deuxième cas, le couvercle est opaque sauf au niveau de parties transparentes reproduisant, sur le couvercle, le motif souhaité. Dans les deux cas, les réalisations proposent un rétro éclairage des touches. La lumière n'est pas concentrée sur un point lumineux spécifique de l'interface utilisateur. L'intensité lumineuse transmise n'est donc pas optimum. En conséquence, lorsque la luminosité de la pièce est forte, il peut être difficile de constater l'éclairage de la LED à travers le cache. Pour un même retour d'information lumineux, il faudrait alors augmenter la puissance de la LED au détriment de la consommation. De plus, ces dispositifs sont assez complexes car ils nécessitent l'utilisation d'une pièce spécifique formant les caches. La contrainte dimensionnelle est moins importante dans le domaine de l'électroménager que pour les dispositifs domotiques ce qui rend moins critique l'implantation de ces caches.

Le brevet US 7,232,973 décrit un dispositif intégrant également les éléments précédents ainsi que des guides lumière en vis-à-vis des LED de retour d'information. Ces guides lumière traversent le couvercle couvrant les capteurs capacitifs et formant l'interface utilisateur. En conséquence, l'intensité des LED est correctement transmise ce qui assure un bon retour d'information. Cependant, la structure du couvercle est complexe du fait de la présence de guides lumière à intégrer. De plus, les sensations au toucher et l'étanchéité du dispositif sont dégradées. Si l'on tente de résoudre ces problèmes en conservant cette structure, on se heurte à de sévères problèmes techniques, notamment de tolérancement et de réalisation du couvercle et des guides lumière.

On connaît du document DE 102 59 297 une plaque de cuisson comprenant une plaque de verre dans laquelle sont envoyés des rayons lumineux et sous laquelle est disposé un dispositif de réflexion permettant aux rayons lumineux de traverser la plaque de verre pour sortir au-dessus de celle-ci au niveau d'un capteur. Dans cette application relative aux plaques de cuisson, des lampes peuvent être disposées au niveau des chants d'une plaque transparente : ce n'est pas le cas des applications relatives à des dispositifs de commande d'appareils domotiques destinés au confort thermique, visuel ou de sécurité dans un bâtiment. Des problèmes d'encombrement se poseraient alors.

On connaît du document WO 2008/22 866 une plaque recouvrant un capteur à contact ou un capteur de proximité. Cette plaque comprend un guide de lumière réalisé dans une matière différente de la plaque pour guider des rayons lumineux d'une source lumineuse à la face supérieure de la plaque. Une telle réalisation d'une plaque comprenant un guide de lumière pose des problèmes de coûts. En outre, une plaque de couverture bi-matière n'est pas conseillée pour une pièce d'aspect telle qu'un interrupteur. D'une part, la discontinuité de la matière est visible et inesthétique. D'autre part, du point de vue de la réalisation, la discontinuité de la matière peut engendrer un décalage de surface ou pire, des bavures identifiables au toucher. Cela limite les réalisations à des matières pouvant être surmoulées.

Les documents US 5 917 165, WO 2007/053966, US 5636729 représentent des dispositifs de commande connus.

Le but de l'invention est de fournir un dispositif de commande remédiant à ces problèmes et améliorant les dispositifs de commande connus de l'art antérieur. En particulier, l'invention propose un dispositif de commande ayant une structure simple, compact, économique, ergonomique et présentant une excellente étanchéité et aucune discontinuité de surface détectable au toucher non souhaitée.

Selon l'invention, le dispositif de commande est défini par la revendication 1.

Différents modes de réalisation du dispositif sont définis par les revendications dépendantes 2 à 8.

L'invention sera mieux comprise à la lecture de la description qui va suivre, donnée uniquement à titre d'exemple et faite en se référant aux dessins annexés sur lesquels :
- la figure 1 est une représentation schématique en perspective d'un premier mode de réalisation d'un dispositif de commande selon l'invention ;
- la figure 2 est une vue de dessus de ce premier mode de réalisation ;
- la figure 3 est une vue en coupe partielle de ce premier mode de réalisation selon la ligne I-I de la figure 2 ;
- la figure 4 est une vue en coupe partielle de ce premier mode de réalisation selon la ligne II-II de la figure 3 ;
- la figure 5 est une vue en coupe partielle d'un deuxième mode de réalisation selon la ligne I-I à la figure 2.

L'invention propose un dispositif de commande comprenant au moins un capteur capacitif ou touche sensitive, disposé sous un couvercle constituant une interface utilisateur et auquel une source lumineuse est associée. Celle-ci est alimentée lorsque la touche est activée. Pour guider la lumière émise vers une zone spécifique de l'interface utilisateur, le couvercle forme un guide lumière, le couvercle et le guide de lumière sont venus d'une même pièce, par exemple grâce à un procédé d'injection simple et économique. Ainsi, le couvercle et le guide de lumière sont réalisés en une même matière. La zone spécifique est située au droit du capteur capacitif, c'est-à-dire, à l'intérieur de la projection du contour extérieur du capteur sur le couvercle selon une direction normale à la face de détection du capteur. D'une part, cette zone permet d'indiquer où se trouve le capteur capacitif activé. L'ergonomie est alors simple et évidente. Si j'active une touche sensitive, celle-ci se matérialise par un point lumineux. Je sais quel capteur j'ai sélectionné et s'il est activé. D'autre part, cela permet de rendre plus compact le dispositif. L'encombrement est réduit en obtenant deux fonctions pour un même emplacement sur le couvercle, à savoir, une activation d'une touche et un retour d'information de son activation. Enfin, en réalisant le guide lumière avec le couvercle, notamment en une unique pièce d'un même matériau, par exemple par injection d'une matière plastique, le dispositif est plus simple à réaliser et plus économique. Bien entendu, la matière du couvercle doit permettre le guidage de la lumière. Elle doit être translucide au moins au niveau du guide lumière. Un plastron peut être accolé au couvercle si on souhaite améliorer le visuel de l'interface. Une plaque teintée dans la masse peut ainsi cacher le circuit électronique et/ou les touches sensitives situés dessous. Alternativement, le couvercle translucide peut comprendre un revêtement opaque sur sa face inférieure en dehors des zones des guides lumière. Un autre avantage d'utiliser un couvercle formant le guide lumière est d'assurer une parfaite étanchéité au niveau de l'interface utilisateur. De plus, un tel couvercle présente une continuité de matière entre la face interface utilisateur et la face inférieure du guide lumière située proche du capteur capacitif. Cette liaison entre l'interface utilisateur et le capteur contribue à améliorer la sensibilité du capteur, la constante diélectrique étant plus uniforme sur cette ligne de champ. Comme nous l'avons vu, le guide lumière permet d'obtenir une intensité lumineuse optimum au niveau de l'interface utilisateur.

Préférentiellement, le capteur capacitif entoure au moins partiellement la source lumineuse. De préférence, le capteur a sensiblement une forme annulaire. Cette forme peut présenter des discontinuités. Cela permet une implantation des éléments du dispositif plus compacte. Cette disposition facilite également le guidage de la lumière au droit du capteur capacitif. La source de lumière étant déjà au centre de la touche, un guide lumière de forme simple permet donc de diriger facilement la lumière vers un point du couvercle au droit du capteur. Ce peut être un cylindre ou un cône tronqué droit, formes simples à réaliser et assurant un bon guidage de la lumière. Il est avantageux d'avoir un guide lumière solide, c'est-à-dire, une partie de pièce en matière translucide à travers laquelle le flux lumineux passe, pour pouvoir concentrer ce flux lumineux en un point de l'interface utilisateur. Préférentiellement, le guide lumière fait saillie par rapport à la face inférieure du couvercle. Cette protubérance permet de s'approcher au plus près de la source lumineuse et donc d'améliorer le guidage optique de la partie guide lumière du couvercle. De plus, le couvercle peut être d'épaisseur plus faible en dehors des guides-lumière. L'injection de la pièce est alors améliorée et le risque de défaut (bulle d'aire, retassure... ) diminué. Astucieusement, il pourrait être envisagé d'utiliser les guides lumière pour faciliter l'éjection de la pièce moulée (éjecteur).

Avantageusement, la surface émettrice de la source lumineuse est au même niveau de la face de détection de la touche sensitive ou plus proche du couvercle. Avec cette disposition, le capteur ne perturbe pas la diffusion de la lumière en cachant une zone. De plus, cela laisse plus de volume pour réaliser la partie guide lumière dans le couvercle. De manière avantageuse, la source lumineuse et la touche sensitive sont implantées sur la même face du circuit imprimé composant le circuit électronique. Le circuit électronique comprend le circuit imprimé ainsi que les moyens matériels et logiciels permettant de commander les appareils domotiques associés au dispositif de commande ainsi que les sources lumineuses associés aux touches sensitives.

Pour améliorer l'indication de l'emplacement des touches sensitives, le couvercle peut comprendre un repère tactile et/ou visuel sur sa face supérieure au niveau de la zone du couvercle où la lumière est dirigée par le guide lumière. Ce peut-être un creux, une protubérance ou une surface bombée. De plus, correctement dimensionné, ce repère peut également améliorer les caractéristiques optiques du signal lumineux obtenu. Une surface bombée peut avoir des effets optiques analogues à une lentille convergente. Le retour d'information s'avère alors plus performant.

La compacité du dispositif peut aussi être améliorée en utilisant une pastille sensitive comme capteur capacitif. Cette plaque circulaire métallique est directement gravée sur le circuit imprimé ce qui réduit l'épaisseur du dispositif.

L'allumage de la source lumineuse peut avoir lieu tant que la touche virtuelle est activée c'est-à-dire tant que le capteur capacitif détecte la présence d'un doigt et/ou se prolonger pendant un temps prédéfini après activation. Alternativement, et lorsque par exemple la touche permet de commander l'état marche/arrêt d'un appareil, l'allumage de la source lumineuse peut traduire l'état de fonctionnement de l'appareil.

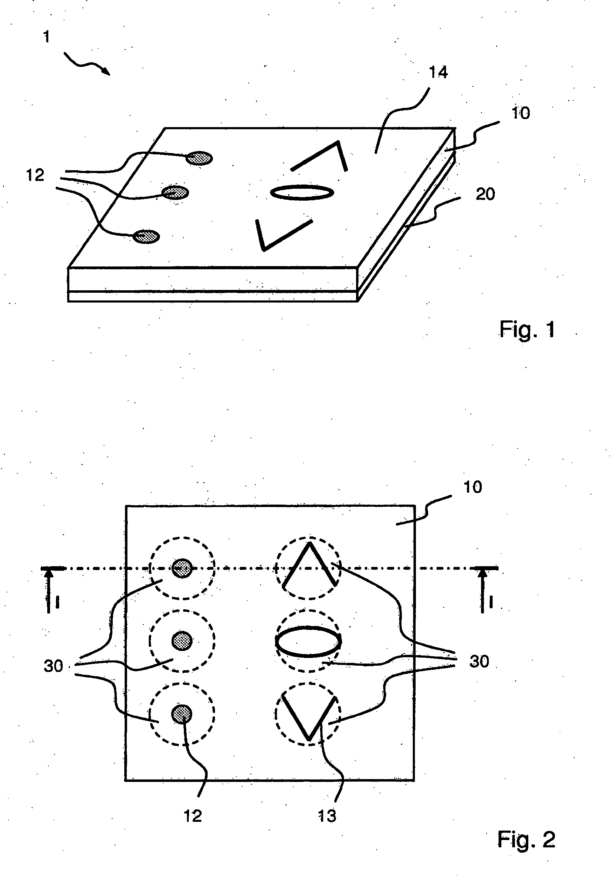

Le dispositif de commande 1 représenté aux figures 1 à 4 est l'illustration d'un module encastrable dans un cadre d'un interrupteur mural ou le boîtier d'une télécommande.

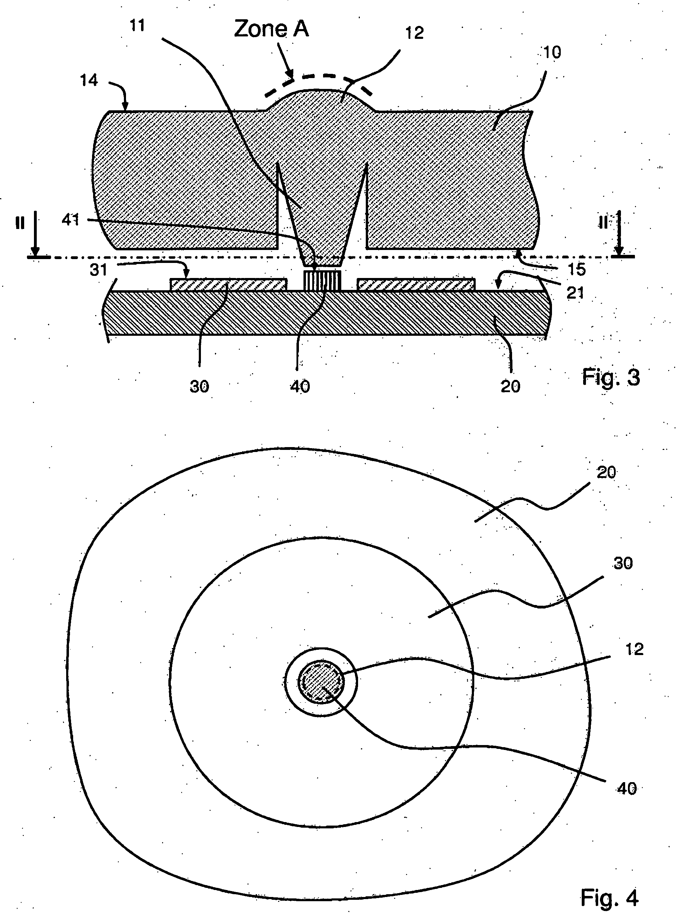

Ce dispositif de commande 1 comprend un couvercle 10 réalisé dans une matière translucide. La face supérieure 14 de ce couvercle forme l'interface avec l'utilisateur. Ce couvercle est monobloc et recouvre les organes de commande du dispositif. Les organes de commande et une source lumineuse 41 sont situés sous une face inférieure 15 de ce couvercle. Ces organes comprennent un circuit électronique et des capteurs capacitifs 30. Dans notre illustration, ces capteurs sont réalisés par des pastilles sensitives disposées sur le circuit imprimé 20 du circuit électronique. Ces touches sont agencées au droit d'emplacements spécifiques de l'interface utilisateur de manière à ce qu'une touche est activée si un doigt est présent dans la zone spécifique correspondante. Le dispositif représenté comprend six touches sensitives comme le montre la figure 2. Trois touches sont disposées sous des pictogrammes 13 représentatifs de commande d'actionnement d'un appareil domotique commandé par le dispositif de commande. Par exemple, pour un volet roulant, une flèche vers le bas représente la fermeture de l'écran. Ainsi, si on place un doigt au-dessus de ce signe, on ordonne la fermeture du volet roulant. Le retour d'information est direct car on voit l'écran se fermer. Trois autres touches, à gauche, sont disposées au niveau de protubérances 12, ces dernières matérialisant ainsi l'emplacement des touches sensitives. Les fonctions réalisées par ces touches ne permettent pas d'avoir un retour d'information direct. Ce peut être, par exemple, la sélection d'un appareil domotique à commander. Dans ce cas, il est nécessaire de générer un retour d'information pour s'assurer que la sélection a été effectivement faite. Pour cela, un retour d'information visuel est prévu au niveau de l'interface utilisateur. Les protubérances 12 s'illuminent grâce à des sources lumineuses comme des diodes électroluminescentes ou LED placées sous le couvercle. La lumière émise par ces sources lumineuses est dirigée jusqu'à ces protubérances par le biais d'un guide lumière 11 intégralement formé avec le couvercle 10, c'est-à-dire que le couvercle et le guide lumière sont monobloc : ils ne forment qu'une seule pièce. Dans notre exemple, la source lumineuse est fixée sur le circuit imprimé au centre de la pastille sensitive en forme d'anneau, comme cela est représenté à la figure 4. Le guide lumière en forme de cône tronqué droit est positionné juste au-dessus de la LED. A la base du tronc de cône, au niveau de la face supérieure 14 du couvercle, celui-ci présente une surface bombée constituant la protubérance 12. Selon une variante, il n'y a pas de protubérance ou d'autres formes matérialisant l'emplacement des touches sensitives.

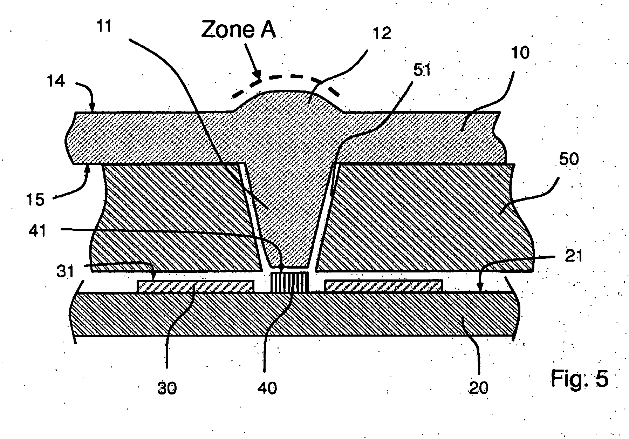

La LED peut être éloignée de la surface inférieure 15 du couvercle. Dans ce cas, il est souhaitable que le guide lumière fasse saillie de cette face inférieure pour être au plus près de la source lumineuse et pour transmettre au mieux le signal lumineux. La solution alternative décrite à la figure 5 consiste à intercaler un plastron 50 entre le couvercle et le circuit imprimé. En étant opaque, ce support peut cacher le circuit imprimé qui pourrait être visible à travers le couvercle translucide. D'autre part, ce support peut également filtrer un éventuel rayonnement lumineux parasite de la LED vers une zone du couvercle non souhaitée. Une ouverture 51 dans le plastron permet de loger une partie du guide lumière du couvercle.

La surface émettrice 41 de la LED 40 est, dans nos illustrations, plus proche de la face inférieure 15 du couvercle 10 que la face de détection 31 des moyens des capteurs capacitifs 30. La LED et les capteurs capacitifs étant implantés sur une même face 21 du circuit imprimé 20 du circuit électronique.

La face inférieure 15 peut présenter une répétition périodique d'un relief d'aspect, la répétition étant de préférence régulière. Les reliefs sont par exemple de type pyramidal ou de type sensiblement pyramidal, notamment de type pyramidal à base carrée. Néanmoins, les reliefs peuvent être pyramidaux à base polygonale autre que carrée, comme par exemple à base triangulaire ou à base hexagonale. Les reliefs peuvent aussi être coniques ou sensiblement coniques, notamment coniques de révolution. Ainsi, dans le cas où la surface inférieure ne serait pas plane, le guide lumière faisant saillie de cette face signifie que l'extrémité de ce guide lumière, située proche de la source lumineuse, est plus éloignée de la face supérieure du couvercle que n'importe quelle partie de la face inférieure, pour autant que cette partie n'ait pas une fonction spécifique. Un guide lumière, un moyen de fixation ou les bords du couvercle peuvent constituer des fonctions spécifiques. Par contre, des reliefs d'aspect ne constituent pas une fonction spécifique au sens de l'invention. Ainsi, l'extrémité du guide lumière est plus éloignée que les sommets des reliefs répétés de cette surface inférieure. Outre le fait de rapprocher le guide lumière au plus près de la source lumineuse, cette conception permet de placer le plastron opaque entre le couvercle et le circuit imprimé, limitant ainsi la diffusion de la lumière en dehors du guide lumière.

Les modes de réalisations précédents sont particulièrement adaptés pour un couvercle sensiblement plan, sans ouverture. Mais, le concept peut également s'appliquer pour des solutions mixtes où le couvercle comprend des ouvertures pour loger des touches mécaniques. Dans ce cas, le dispositif comprendra à la fois des touches sensitives capacitives et des touches mécaniques.

## Revendications

1. Dispositif de commande (1) d'au moins un appareil domotique, comprenant :
- un couvercle (10) recouvrant un capteur capacitif (30) associé à un circuit électronique,
- une source lumineuse (40) pilotée par le circuit électronique et placée sous le couvercle,
- un guide lumière (11) ayant une forme de cylindre droit ou de tronc de cône droit et permettant de diriger la lumière émise par la source lumineuse uniquement vers une zone (A) du couvercle située à l'intérieur de la projection du contour extérieur du capteur sur le couvercle selon une direction normale à la face de détection du capteur,
**caractérisé en ce que** le couvercle forme le guide lumière, **en ce que** le couvercle et le guide lumière sont monobloc, **en ce que** la matière du couvercle permet le guidage de la lumière, **en ce que** le capteur capacitif entoure la source lumineuse et **en ce que** le couvercle recouvre des organes de commande, les organes de commande du dispositif comprenant un circuit électronique et des capteurs capacitifs (30), le guide lumière étant une partie de pièce en matière translucide à travers laquelle un flux lumineux passe et permettant de concentrer le flux lumineux en un point d'une interface utilisateur.

2. Dispositif de commande selon la revendication précédente, **caractérisé en ce que** le guide lumière fait saillie d'une face inférieure (15) du couvercle.

3. Dispositif de commande selon l'une des revendications précédentes, **caractérisé en ce que** la surface émettrice (41) de la source lumineuse est au même niveau que la face de détection (31) du capteur capacitif ou plus proche du couvercle.

4. Dispositif de commande selon l'une des revendications précédentes, **caractérisé en ce que** le couvercle forme un repère tactile et/ou visuel (12) sur sa face supérieure (14) au niveau de la zone (A) du couvercle où la lumière est dirigée par le guide lumière.

5. Dispositif de commande selon l'une des revendications précédentes, **caractérisé en ce que** le capteur capacitif comprend une pastille sensitive disposée sur un circuit imprimé du circuit électronique.

6. Dispositif de commande selon l'une des revendications précédentes, **caractérisé en ce qu'**un plastron (50) est intercalé entre le couvercle et le circuit imprimé du circuit électronique.

7. Dispositif de commande selon la revendication 6, **caractérisé en ce que** le plastron est opaque et comprend des ouvertures pour le passage du flux lumineux émis par la source lumineuse.

## Patentansprüche

1. Bedienungsvorrichtung (1) für mindestens ein Gerät zur Gebäudeautomatisierung, umfassend:
- einen Deckel (10), der einen kapazitiven Sensor (30), der einer elektronischen Schaltung zugeordnet ist, bedeckt,
- eine Lichtquelle (40), die von der elektronischen Schaltung gesteuert wird und unter dem Deckel angeordnet ist,
- einen Lichtleiter (11), der die Form eines geraden oder kegelstumpfartigen Zylinders hat und es ermöglicht, das von der Lichtquelle entsandte Licht nur zu einer Zone (A) des Deckels zu leiten, die sich innerhalb der Projektion der äußeren Kontur des Sensors auf den Deckel in eine Richtung senkrecht auf die Erfassungsfläche des Sensors befindet,
**dadurch gekennzeichnet, dass** der Deckel den Lichtleiter bildet, dass der Deckel und der Lichtleiter aus einem Stück sind, dass das Material des Deckels die Leitung des Lichts ermöglicht, dass der kapazitive Sensor die Lichtquelle umgibt, und dass der Deckel die Bedienungselemente bedeckt, wobei die Bedienungselemente der Vorrichtung eine elektronische Schaltung und kapazitive Sensoren (30) umfassen, wobei der Lichtleiter ein Teil eines Stücks aus durchscheinendem Material ist, durch den ein Lichtstrom hindurchgeht, und es ermöglicht, den Lichtstrom an einem Punkt einer Benutzerschnittstelle zu konzentrieren.

2. Bedienungsvorrichtung nach dem vorhergehenden Anspruch, **dadurch gekennzeichnet, dass** der Lichtleiter aus einer Unterseite (15) des Deckels herausragt.

3. Bedienungsvorrichtung nach einem der vorhergehenden Ansprüche, **dadurch gekennzeichnet, dass** die Sendefläche (41) der Lichtquelle auf demselben Niveau wie die Erfassungsfläche (31) des kapazitiven Sensors oder näher zum Deckel ist.

4. Bedienungsvorrichtung nach einem der vorhergehenden Ansprüche, **dadurch gekennzeichnet, dass** der Deckel eine Tast- und/oder Sichtmarke (12) auf ihrer Oberseite (14) im Bereich der Zone (A) des Deckels, zu der das Licht durch den Lichtleiter geleitet wird, bildet.

5. Bedienungsvorrichtung nach einem der vorhergehenden Ansprüche, **dadurch gekennzeichnet, dass** der kapazitive Sensor ein sensitives Plättchen umfasst, das auf einer gedruckten Schaltung der elektronischen Schaltung angeordnet ist.

6. Bedienungsvorrichtung nach einem der vorhergehenden Ansprüche, **dadurch gekennzeichnet, dass** ein Plastron (50) zwischen dem Deckel und der gedruckten Schaltung der elektronischen Schaltung angeordnet ist.

7. Bedienungsvorrichtung nach Anspruch 6, **dadurch gekennzeichnet, dass** das Plastron opak ist und Öffnungen für den Durchgang des von der Lichtquelle entsandten Lichtstroms umfasst.

## Claims

1. Control device (1) for at least one home automation apparatus, comprising:
- a cover (10) covering a capacitive sensor (30) associated with an electronic circuit,
- a light source (40) driven by the electronic circuit and placed under the cover,
- a light guide (11) in the form of a straight cylinder or straight **frustum** and making it possible to direct the light emitted by the light source only towards an area (A) of the cover situated inside the projection of the outer contour of the sensor on the cover in a direction normal to the detection face of the sensor,
**characterized in that** the cover forms the light guide, **in that** the cover and the light guide are of a single piece, **in that** the material of the cover makes it possible to guide the light, **in that** the capacitive sensor surrounds the light source and **in that** the cover covers control members, the control members of the device comprising an electronic circuit and capacitive sensors (30), the light guide being part of a piece made of translucent material through which a light flux passes and that makes it possible to concentrate the light flux at a point of a user interface.

2. Control device according to the preceding claim, **characterized in that** the light guide protrudes from a bottom face (15) of the cover.

3. Control device according to one of the preceding claims, **characterized in that** the emitting surface (41) of the light source is at the same level as the detection face (31) of the capacitive sensor or closer to the cover.

4. Control device according to one of the preceding claims, **characterized in that** the cover forms a touch-sensitive and/or visual reference frame (12) on its top face (14) in the area (A) of the cover where the light is directed by the light guide.

5. Control device according to one of the preceding claims, **characterized in that** the capacitive sensor comprises a sensitive pad arranged on a printed circuit of the electronic circuit.

6. Control device according to one of the preceding claims, **characterized in that** a protective panel (50) is inserted between the cover and the printed circuit of the electronic circuit.

7. Control device according to Claim 6, **characterized in that** the protective panel is opaque and comprises openings for the passage of the light flux emitted by the light source.
